(19) Europäisches Patentamt
European Patent Office
Office européen des brevets

(11) **EP 4 560 519 A1**

(12) **EUROPEAN PATENT APPLICATION**
published in accordance with Art. 153(4) EPC

(43) Date of publication:
**28.05.2025 Bulletin 2025/22**

(21) Application number: **22953400.3**

(22) Date of filing: **30.07.2022**

(51) International Patent Classification (IPC):
**G06F 30/27** (2020.01)    **G06N 3/08** (2023.01)

(52) Cooperative Patent Classification (CPC):
**G06F 30/27; G06N 3/08**

(86) International application number:
**PCT/CN2022/109277**

(87) International publication number:
**WO 2024/026583 (08.02.2024 Gazette 2024/06)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
- **Huawei Technologies Co., Ltd.**
  **Shenzhen, Guangdong 518129 (CN)**
- **Tsinghua University**
  **Beijing 100084 (CN)**

(72) Inventors:
- **ZHU, Zheqi**
  **Beijing 100084 (CN)**

- **FAN, Pingyi**
  **Beijing 100084 (CN)**
- **PENG, Chenghui**
  **Shenzhen, Guangdong 518129 (CN)**
- **WANG, Fei**
  **Shenzhen, Guangdong 518129 (CN)**
- **WAN, Shuo**
  **Beijing 100084 (CN)**
- **LU, Jiaxun**
  **Shenzhen, Guangdong 518129 (CN)**

(74) Representative: **Körber, Martin Hans**
**Mitscherlich PartmbB**
**Patent- und Rechtsanwälte**
**Karlstraße 7**
**80333 München (DE)**

(54) **COMMUNICATION METHOD AND COMMUNICATION APPARATUS**

(57)     Embodiments of this application provide a communication method and a communication apparatus. The method includes: A base station determines to calculate a first importance weight, where the first importance weight is an importance weight of each category of data samples in multiple categories of data samples corresponding to a terminal device. The base station sends first indication information to the terminal device, where the first indication information indicates the terminal device to send a first parameter, and the first parameter is used to calculate the first importance weight by the base station. The base station receives the first parameter sent by the terminal device. The base station calculates the first importance weight based on the first parameter. The base station sends the first importance weight to the terminal device. This method resolves problems of poor model precision and slow convergence resulting from non-independent and identical distribution of local data of terminal devices participating in federated training.

Method 300

| | |
|---|---|
| Base station | Terminal device |

S310: The base station determines to calculate a first importance weight

S320: The base station sends first indication information to the terminal device

S330: The terminal device sends a first parameter to the base station based on the first indication information

S340: The base station calculates the first importance weight based on the first parameter

S350: The base station sends the first importance weight to the terminal device

S360: The terminal device trains a next local model based on the first importance weight

FIG. 3

## Description

### TECHNICAL FIELD

Embodiments of this application relate to the communication field, and in particular, to a communication method and a communication apparatus.

### BACKGROUND

As an emerging distributed learning framework, federated learning is widely considered as a distributed system with high communication efficiency by virtue of its concise model training paradigm and parameter passing rules. A core idea of federated learning is to construct, through distributed model training between a plurality of data sources with local data, a global model based on virtual fusion data by exchanging model parameters or intermediate results without exchanging local individuals or sample data.

However, in related theories, experimental research, and engineering practice, non-independent and identically distributed local user data is considered as a key challenge for federated learning. The non-independent and identical distribution characteristic of local data at a distribution level is mainly manifested in two aspects: 1. imbalance in categories of training samples in the local data; and 2. inconsistency in distribution of categories of local data between distributed users (terminal devices). The imbalance in categories affects a training effect of a local model, and the unbalanced sample category distribution is prone to cause overfitting, poor generalization performance on test sets, or other problems. The inconsistency in distribution makes local models of distributed users have different training trends and tendencies, resulting in poor precision and convergence of a federated global model.

### SUMMARY

Embodiments of this application provide a communication method and a communication apparatus, to resolve problems of poor model precision and slow convergence by introducing importance weight sampling for each category of sample data of a terminal device and an interaction mechanism between a base station and the terminal device, where the problems arise from non-independent and identical distribution of local data of terminal devices participating in federated training. An importance weight is derived based on related theories by taking the following information into consideration: imbalance in distribution of different categories of samples and a gradient Lipschitz coefficient that affects model convergence, allowing pattern features of different categories of samples to be learned by local models, and ensuring a controllable deviation between local models.

According to a first aspect, a communication method is provided. A base station determines to calculate a first importance weight. The first importance weight is an importance weight of each category of data samples in multiple categories of data samples corresponding to a terminal device. The base station sends first indication information to the terminal device. The first indication information indicates the terminal device to send a first parameter. The first parameter is used to calculate the first importance weight by the base station. The base station receives the first parameter sent by the terminal device. The base station calculates the first importance weight based on the first parameter. The base station sends the first importance weight to the terminal device.

According to the communication method provided in this embodiment of this application, the problems of poor model precision and slow convergence are resolved by introducing importance weight sampling of each category of sample data of the terminal device and an interaction mechanism between the base station and the terminal device, where the problems arise from non-independent and identical distribution of local data of terminal devices participating in federated training. The importance weight is derived based on related theories by taking the following information into consideration: imbalance in distribution of different categories of samples and a gradient Lipschitz coefficient that affects model convergence, allowing pattern features of the different categories of samples to be learned by local models, and ensuring a controllable deviation between local models. In addition, deploying update of the importance weight in the base station, can fully utilize a computing power advantage of the base station, so as to release computing power of the terminal device.

With reference to the first aspect, in some implementations of the first aspect, the first parameter includes distribution of local data of the terminal device.

With reference to the first aspect, in some implementations of the first aspect, the first parameter includes the distribution of the local data of the terminal device and a gradient corresponding to the local data.

With reference to the first aspect, in some implementations of the first aspect, the base station determines distribution of global data. The distribution of the global data is distribution of local data corresponding to a plurality of terminal devices associated with the base station during federated training.

That the base station calculates the first importance weight based on the first parameter includes:

The base station calculates the first importance weight based on the first parameter and the distribution of the global data.

With reference to the first aspect, in some implementations of the first aspect, the first importance weight satisfies the following condition:

$$w_{N,n} = \frac{p_n + \alpha_{N,n}\Gamma_N}{p_{N,n}},$$

where

$p_{N,n}$ represents the distribution of the global data, where the distribution of the global data is the distribution of the local data corresponding to the plurality of terminal devices associated with the base station during federated training; $p_n$ is the distribution of the local data corresponding to the terminal device; N represents a quantity of the plurality of terminal devices; n represents that the terminal device is an $n^{th}$ terminal device; $\alpha_{N,n}$ is a gradient Lipschitz deviation of each category of data samples; and $\Gamma_N$ is a minimum non-negative value in $\frac{p_n - \sigma p_{N,n}}{-\alpha_{N,n}}$.

According to a second aspect, a communication method is provided, including: A terminal device receives first indication information sent by a base station. The first indication information indicates that the first indication information indicates the terminal device to send a first parameter. The first parameter is used to calculate a first importance weight by the base station. The terminal device sends the first parameter to the base station based on the first indication information. The terminal device receives the first importance weight sent by the base station. The terminal device trains a next local model based on the first importance weight.

According to the communication method provided in this embodiment of this application, the problems of poor model precision and slow convergence are resolved by introducing importance weight sampling of each category of sample data of the terminal device and an interaction mechanism between the base station and the terminal device, where the problems arise from non-independent and identical distribution of local data of terminal devices participating in federated training. The importance weight is derived based on related theories by taking the following information into consideration: imbalance in distribution of different categories of samples and a gradient Lipschitz coefficient that affects model convergence, allowing pattern features of the different categories of samples to be learned by local models, and ensuring a controllable deviation between local models. In addition, deploying update of the importance weight in the base station, can fully utilize a computing power advantage of the base station, so as to release computing power of the terminal device.

With reference to the second aspect, in some implementations of the second aspect, the first parameter includes distribution of local data of the terminal device.

With reference to the second aspect, in some implementations of the second aspect, the first parameter includes the distribution of the local data of the terminal device and a gradient corresponding to the local data.

With reference to the second aspect, in some implementations of the second aspect, the first importance weight satisfies the following condition:

$$w_{N,n} = \frac{p_n + \alpha_{N,n}\Gamma_N}{p_{N,n}},$$

where

$p_{N,n}$ represents distribution of global data, where the distribution of the global data is distribution of local data corresponding to a plurality of terminal devices associated with the base station during federated training; $p_n$ is the distribution of the local data corresponding to the terminal device; N represents a quantity of the plurality of terminal devices; n represents that the terminal device is an $n^{th}$ terminal device; $\alpha_{N,n}$ is a gradient Lipschitz deviation of each category of data samples; and $\Gamma_N$ is a minimum non-negative value in $\frac{p_n - \sigma p_{N,n}}{-\alpha_{N,n}}$.

According to a third aspect, a communication method is provided, including: A base station sends second indication information to a terminal device. The second indication information indicates the terminal device to send a second parameter. The second parameter is used to calculate a second importance weight. The second importance weight is an importance weight of each category of data samples in multiple categories of data samples corresponding to the terminal device. The base station receives the second parameter sent by the terminal device. The base station determines that the terminal device calculates the second importance weight. The base station sends third indication information to the terminal device. The third indication information indicates that the terminal device calculates the second importance weight.

According to the communication method provided in this embodiment of this application, a terminal device with remaining computing power or low federated update timeliness may update an importance weight locally, so that system scheduling pressure is reduced, and overall efficiency is further improved.

With reference to the third aspect, in some implementations of the third aspect, the second parameter includes distribution of local data of the terminal device.

With reference to the third aspect, in some implementations of the third aspect, the second parameter includes the distribution of the local data of the terminal device and a gradient corresponding to the local data.

With reference to the third aspect, in some implementations of the third aspect, the base station determines distribution of global data. The distribution of the global data is distribution of local data corresponding to a plurality of terminal devices associated with the base station during federated training. The base station sends the distribution of the global data to the terminal device.

With reference to the third aspect, in some implementations of the third aspect, the second importance weight satisfies the following condition:

$$w_{N,n} = \frac{p_n + \alpha_{N,n}\Gamma_N}{p_{N,n}},$$

where

$p_{N,n}$ represents the distribution of the global data, where the distribution of the global data is the distribution of the local data corresponding to the plurality of terminal devices associated with the base station during federated training; $p_n$ is the distribution of the local data corresponding to the terminal device; N represents a quantity of the plurality of terminal devices; n represents that the terminal device is an $n^{th}$ terminal device; $\alpha_{N,n}$ is a gradient Lipschitz deviation of each category of data samples; and $\Gamma_N$ is a minimum non-negative value in $\frac{p_n - \sigma p_{N,n}}{-\alpha_{N,n}}$.

According to a fourth aspect, a communication method is provided, including: A terminal device receives second indication information sent by a base station. The second indication information indicates the terminal device to send a second parameter to the base station, the second parameter is used to calculate a second importance weight, and the second importance weight is an importance weight of each category of data samples in multiple categories of data samples corresponding to the terminal device. The terminal device sends the second parameter to the base station based on the second indication information. The terminal device receives third indication information sent by the base station. The third indication information indicates that the terminal device calculates the second importance weight. The terminal device calculates the second importance weight based on the second parameter. The terminal device trains a next local model based on the second importance weight.

According to the communication method provided in this embodiment of this application, a terminal device with remaining computing power or low federated update timeliness may update an importance weight locally, so that system scheduling pressure is reduced, and overall efficiency is further improved.

With reference to the fourth aspect, in some implementations of the fourth aspect, the second parameter includes distribution of local data of the terminal device.

With reference to the fourth aspect, in some implementations of the fourth aspect, the second parameter includes the distribution of the local data of the terminal device and a gradient corresponding to the local data.

With reference to the fourth aspect, in some implementations of the fourth aspect, the base station determines distribution of global data. The distribution of the global data is distribution of local data corresponding to a plurality of terminal devices associated with the base station during federated training. The base station sends the distribution of the global data to the terminal device.

With reference to the fourth aspect, in some implementations of the fourth aspect, the second importance weight satisfies the following condition:

$$w_{N,n} = \frac{p_n + \alpha_{N,n}\Gamma_N}{p_{N,n}},$$

where

$p_{N,n}$ represents the distribution of the global data, where the distribution of the global data is the distribution of the local data corresponding to the plurality of terminal devices associated with the base station during federated training; $p_n$ is the distribution of the local data corresponding to the terminal device; N represents a quantity of the plurality of terminal devices; n represents that the terminal device is an $n^{th}$ terminal device; $\alpha_{N,n}$ is a gradient Lipschitz deviation of each category of data samples; and $\Gamma_N$ is a minimum non-negative value in $\frac{p_n - \sigma p_{N,n}}{-\alpha_{N,n}}$.

According to a fifth aspect, a method for calculating an importance weight is provided, including: A first device calculates a gradient Lipschitz coefficient of each category of data samples in multiple categories of data samples in a terminal device based on distribution of local data of the terminal device. The first device calculates an importance weight of each category of data samples in the multiple categories of data samples based on the gradient Lipschitz coefficient of each category of data samples in the multiple categories of data samples, where importance weights of the multiple categories of data samples are used by the terminal device to train a next local model.

With reference to the fifth aspect, in some implementations of the fifth aspect, the first device is a base station.

With reference to the fifth aspect, in some implementations of the fifth aspect, the first device is a terminal device.

With reference to the fifth aspect, in some implementations of the fifth aspect, the importance weight satisfies the following condition:

$$w_{N,n} = \frac{p_n + \alpha_{N,n}\Gamma_N}{p_{N,n}},$$

where

$p_{N,n}$ represents distribution of global data, where the distribution of the global data is distribution of local data corresponding to a plurality of terminal devices associated with the base station during federated training; $p_n$ is the distribution of the local data corresponding to the terminal device; N represents a quantity of the plurality of terminal devices; n represents that the terminal device is an n$^{th}$ terminal device; $\alpha_{N,n}$ is a gradient Lipschitz deviation of each category of data samples; and $\Gamma_N$ is a minimum non-negative value in $\frac{p_n - \sigma p_{N,n}}{-\alpha_{N,n}}$.

According to a sixth aspect, a communication apparatus is provided, including units configured to perform steps of the communication method according to the first aspect and the implementations of the first aspect, or in the third aspect and the implementations of the third aspect.

In a design, the communication apparatus is a communication chip, and the communication chip may include an input circuit or an interface configured to send information or data, and an output circuit or an interface configured to receive information or data.

In another design, the communication apparatus is a communication device (for example, a base station), and the communication chip may include a transmitting machine configured to send information and a receiving machine configured to receive information or data.

According to a seventh aspect, a communication apparatus is provided, including units configured to perform steps of the communication method according to the second aspect and the implementations of the second aspect, or in the fourth aspect and the implementations of the fourth aspect.

In a design, the communication apparatus is a communication chip, and the communication chip may include an input circuit or an interface configured to send information or data, and an output circuit or an interface configured to receive information or data.

In another design, the communication apparatus is a communication device (for example, a terminal device), and the communication chip may include a transmitting machine configured to send information and a receiving machine configured to receive information or data.

According to an eighth aspect, a communication device is provided, including a processor and a memory. The memory is configured to store a computer program. The processor is configured to invoke the computer program from the memory and run the computer program, so that the communication device performs the communication methods according to the first aspect to the fourth aspect and the implementations of the first aspect to the fourth aspect.

Optionally, there are one or more processors, and there are one or more memories.

Optionally, the memory may be integrated with the processor, or the memory and the processor may be separately disposed.

Optionally, the communication device further includes a transmitting machine (transmitter) and a receiving machine (receiver).

According to a ninth aspect, a computer program product is provided. The computer program product includes a computer program (or referred to as code or instructions). When the computer program is run, a computer is enabled to perform the communication methods according to the first aspect to the fourth aspect and the implementations of the first aspect to the fourth aspect.

According to a tenth aspect, a computer-readable medium is provided. The computer-readable medium stores a computer program (or referred to as code or instructions). When the computer program is run on a computer, the computer is enabled to perform the communication methods according to the first aspect to the fourth aspect and the implementations of the first aspect to the fourth aspect.

According to an eleventh aspect, a chip system is provided, including a memory and a processor. The memory is configured to store a computer program, and the processor is configured to invoke the computer program from the memory and run the computer program, to enable a communication device on which the chip system is installed to perform the communication methods according to the first aspect to the fourth aspect and the implementations of the first aspect to the fourth aspect. The chip system may include an input circuit or an interface configured to send information or data, and an output circuit or an interface configured to receive information or data.

## BRIEF DESCRIPTION OF DRAWINGS

FIG. 1 is a diagram of a conventional federated learning framework;
FIG. 2 is a diagram of a system architecture according to an embodiment of this application;
FIG. 3 is an example of a communication method according to an embodiment of this application;
FIG. 4 is a method for calculating a first importance weight by a base station;
FIG. 5 is another example of a communication method according to an embodiment of this application;
FIG. 6 is another example of a communication method according to an embodiment of this application;
FIG. 7 is a diagram of a process in which a base station calculates an importance weight of a terminal device;
FIG. 8 is another example of a communication method according to an embodiment of this application;
FIG. 9 is an example of a diagram of an effect of a communication method according to an embodiment of this application;
FIG. 10 is another example of a diagram of an effect of a communication method according to an embodiment of this application;
FIG. 11 is an example of a communication apparatus according to an embodiment of this application; and
FIG. 12 is another example of a communication apparatus according to an embodiment of this application.

## DESCRIPTION OF EMBODIMENTS

The following describes embodiments of technical solutions of this application in detail with reference to the accompanying drawings. The following embodiments are merely used to describe the technical solutions of this application more clearly, and therefore are merely used as examples, but are not intended to limit the protection scope of this application.

Unless otherwise defined, meanings of all technical and scientific terms used in this specification are the same as those usually understood by a person skilled in the art to which this application belongs. The terms used in this specification are merely intended to describe specific embodiments, but are not intended to limit this application. The terms "include", "have", and any variations thereof in the specification, claims, and accompanying drawings of this application are intended to cover a non-exclusive inclusion.

In the descriptions of embodiments of this application, "a plurality of" means two or more, unless otherwise specifically limited. An "embodiment" mentioned in this specification means that particular features, structures, or characteristics described with reference to this embodiment may be included in at least one embodiment of this application. The phrase shown in various locations in this specification may not necessarily refer to a same embodiment, and is not an independent or optional embodiment exclusive from another embodiment. It is explicitly and implicitly understood by a person skilled in the art that embodiments described in this specification may be combined with another embodiment.

In the descriptions of embodiments of this application, the term "and/or" describes only an association relationship for describing associated objects and represents that three relationships may exist. For example, A and/or B may represent the following three cases: Only A exists, both A and B exist, and only B exists. In addition, the character "/" in this specification generally indicates an "or" relationship between associated objects.

The technical solutions of embodiments of this application may be applied to various communication systems, for example, a global system for mobile communications (Global System for Mobile communications, GSM), a code division multiple access (Code Division Multiple Access, CDMA) system, a wideband code division multiple access (Wideband Code Division Multiple Access, WCDMA) system, a general packet radio service (General Packet Radio Service, GPRS), a long term evolution (Long Term Evolution, LTE) system, an LTE frequency division duplex (Frequency Division Duplex, FDD) system, an LTE time division duplex (Time Division Duplex, TDD) system, a universal mobile telecommunications system (Universal Mobile Telecommunications System, UMTS), a worldwide interoperability for microwave access (Worldwide Interoperability for Microwave Access, WiMAX) communication system, a 5th generation (5th Generation, 5G) system, or a new radio (New Radio, NR) system.

A terminal device in embodiments of this application may be user equipment, an access terminal, a subscriber unit, a subscriber station, a mobile station, a remote station, a remote terminal, a mobile device, a user terminal, a terminal, a wireless communication device, a user agent, or a user apparatus. The terminal device may alternatively be a cellular phone, a cordless phone, a session initiation protocol (Session Initiation Protocol, SIP) phone, a wireless local loop (Wireless Local Loop, WLL) station, a personal digital assistant (Personal Digital Assistant, PDA), a handheld device with a wireless communication function, a computing device, another processing device connected to a wireless modem, a vehicle-mounted device, a wearable device, a terminal device in a 5G network, a terminal device in an evolved public land mobile network (Public Land Mobile Network, PLMN), or the like. This is not limited in embodiments of this application.

The following describes key terms in this application.

It should be noted that, in the descriptions of the key terms, a distributed user may be a terminal device, and a central server may be a base station.

1. Local model

The local model is a model obtained by each distributed user through training based on local data.

2. Global model

The global model is a model for delivery that is obtained by a central server by integrating a plurality of local models.

3. Model aggregation

The model aggregation means that in a federated update round, a central server integrates received model parameters uploaded by distributed users to obtain a global model parameter.

4. Gradient modulus

The gradient modulus is a norm of a gradient of a parameter obtained through backpropagation during model training.

5. Gradient Lipschitz coefficient of a local model

For a local model $\theta_t^k$ and a model $\theta_t^*$ that is centrally trained with all data, and a category $i$ of any training sample $z_{k,i}$ on a user $k$, the gradient Lipschitz coefficient of the local model is a minimum coefficient $L_{k,i}$ that makes

$$\left\| \nabla_\theta \ell\left(z_{k,i}; \theta_t^k\right) - \nabla_\theta \ell\left(z_{k,i}; \theta_t^*\right) \right\| \leq L_{k,i} \left\| \theta_t^k - \theta_t^* \right\|$$

hold true, where $\ell(\cdot)$ is a loss function of a deep learning task.

The following describes a federated learning mode in this application.

As an emerging distributed learning framework, federated learning is widely considered as a distributed system with high communication efficiency by virtue of its concise model training paradigm and parameter passing rules.

In addition, the federated learning mode is a deep communication-computing coupling mode. Specifically, a communication network serves distributed computing, and provides a basic function of information transmission, whereas an intelligent algorithm can also enable the communication network, to optimize system performance.

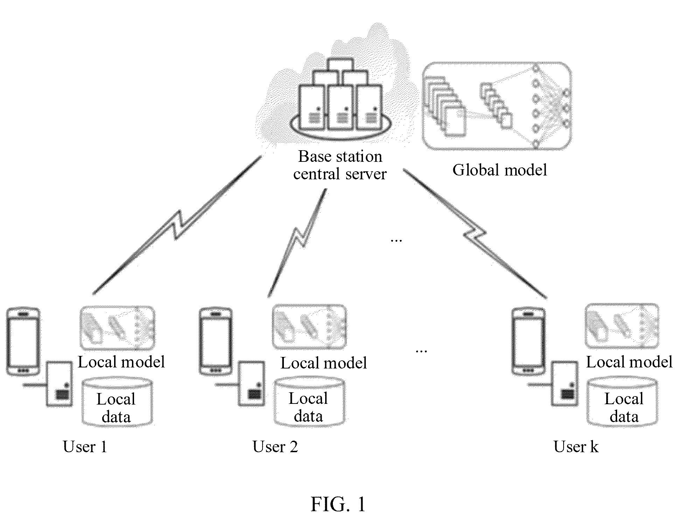

Therefore, a distributed network computing system represented by federated learning is also considered as a core function of a future communication network. A conventional basic federated learning framework is shown in FIG. 1, and may be summarized into two basic steps: local distributed training and central periodic federated integration:

(1) A distributed user trains a local model based on local data.
(2) In a federated update round, the distributed user uploads a local model parameter to a central server. The central server performs model aggregation, and sends a new global model to each distributed user for subsequent local training.

FIG. 1 shows a structure of a regional federation. The central server may be deployed on a regional base station, and provides centralized services such as federated update and overall system scheduling for a distributed user terminal device in the region.

Because model aggregation in a common federated learning algorithm is parameter-level integration, a training effect of the local model has an important impact on performance and a convergence speed of the global model. A deep learning model represented by a neural network is used as a data-driven algorithm, and training data of the deep learning model determines a final training effect to a large extent. Therefore, in a federated learning scenario, the local data indirectly affects the global model, and further affects communication and computing efficiency of a system. Non-independent and identically distributed local user data is considered as a key challenge for federated learning. The following describes several methods for resisting a non-independent and identical distribution characteristic of the local data.

1. Data enhancement

The non-independent and identical distribution characteristic of the local data is resisted from the perspective of data enhancement. For example, a small piece of enhanced data may be distributed and shared to the distributed user by the central server, to resist the non-independent and identical distribution characteristic of the local data.

However, the data enhancement solution requires additional data transmission. Consequently, communication costs are increased, and there may be restrictions such as data privacy.

2. Model level

The non-independent and identical distribution characteristic of the local data is resisted from the perspective of a model level. For example, in model distillation, a loss function of local model training of the distributed user may be modified, so that an output of the local model is similar to an output of the global model, and a difference degree of the local model is reduced.

However, the model distillation solution requires the distributed user to additionally calculate an output of a target model locally. Consequently, a local computing workload of the distributed user is increased.

3. Selection of the distributed user or the data

A selection module for the distributed user or the data is added in a federated learning framework.

In terms of distributed users, a distributed user with good model performance is selected to participate in model aggregation, so that a deviation caused by a poor local model to the global model can be reduced. For example, the base station may resolve a problem of non-independent and identical distribution through local data integration.

In terms of data, each distributed user may select local data with good quality during training. This is beneficial to improving performance of the local model.

4. Re-sampling of a data sample

From the perspective of local training sample sampling of the distributed user, there is a federated learning method based on gradient dynamic sampling of a local training sample. The method provides a sample importance weight through definition. In a $t^{th}$ training periodicity, for a $k^{th}$ user and a training sample $z_{k,i}$ of the local data, a method for calculating an importance weight of the training sample is as follows:

$$\lambda\left(z_{k,i}, t\right) = \sqrt{\left\|\sum_{L} \beta_{k,i}^{t,L} \nabla_{\alpha_{k,i}^{t,L}} \ell\left(z_{k,i}; \theta_t\right)\right\|^2},$$

where

$\beta_{k,i}^{t,L}$ and $\alpha_{k,i}^{t,L}$ are an input and an output of an $L^{th}$ layer of a neural network model in the backpropagation, and $\ell(z_{k,i}; \theta_t)$ is a loss function of the neural network model $\theta_t$ in the training periodicity for a sample $z_{k,i}$, and is, for example, a cross entropy in a classification problem or a mean square error in a regression problem.

The method is operated at the beginning of local training of each distributed user. After each round of federated update, each participating distributed user uses a downloaded global model to calculate an importance weight of each sample in the local data according to the foregoing formula. In a subsequent local training periodicity, the data sample is sampled based on the importance weight for training and updating the local model.

However, the federated learning method based on the gradient dynamic sampling of the local training sample has many disadvantages.

First, the importance weight in the method is defined from a direct perspective. In a global model updated based on the importance weight, a sample with a larger gradient modulus in the backpropagation is given a high importance weight, without considering performance and a convergence speed of the global model after re-sampling. Although this method has some performance improvements in practical experiments, this method lacks theoretical support.

Second, in this method, calculation of the importance weight depends on local sample data of each group of distributed users, and each distributed user needs to download the updated global model and perform backpropagation calculation sample by sample. However, in some actual federated learning systems, especially in a lightweight mobile scenario, a computing resource of a distributed user is preferred, and computing on the distributed user end consumes a large amount of computing time, so that overall efficiency of the system is reduced.

Third, in a federated learning architecture corresponding to the method, interaction between a distributed user and a central server lacks, and global information or computing power support provided by the central server cannot be fully utilized.

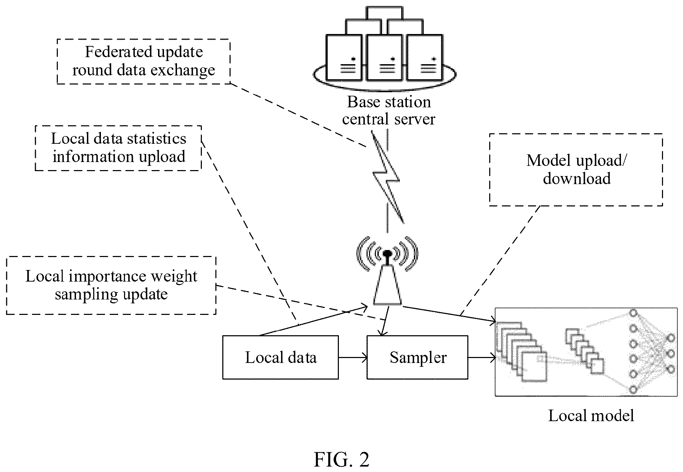

FIG. 2 is a diagram of a system architecture according to an embodiment of this application. FIG. 2 shows a multi-user collaborative federated learning system. A central server (for example, a regional base station) and N (N>1) distributed users participate in training. Training data is divided into M (M>1) categories based on labels. Distribution of local data of each distributed user is $\{p_{N,n}\}$, and distribution of all data is $\{p_n\}$.

The federated learning system shown in FIG. 2 mainly functions in three phases. First, in a federated update round, the central server aggregates collected local models, assists in estimating a gradient Lipschitz coefficient of a sample of each category based on a local model of each distributed user and a new global model obtained in this federated round, and calculates an importance weight. Second, the distributed user receives a new importance weight when downloading the new global model. Third, when training the local model, the distributed user samples a training data sample based on the importance weight.

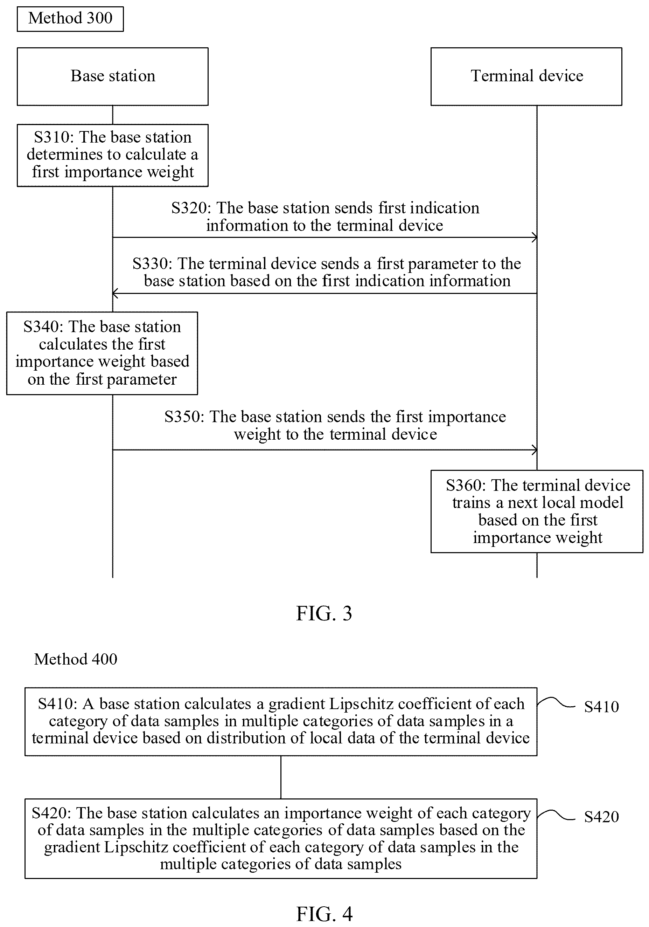

FIG. 3 is an example of a communication method according to an embodiment of this application. In the method, a base station may correspond to a central server, and a terminal device may correspond to a distributed user. As shown in FIG. 3, the method includes the following steps.

S310: The base station determines to calculate a first importance weight.

Specifically, the first importance weight is an importance weight of each category of data samples in multiple categories of data samples corresponding to the terminal device.

It should be noted that, the base station may calculate the first importance weight of the terminal device, or may calculate a first importance weight of another terminal device in a federated learning system related to the base station.

Optionally, the base station may calculate first importance weights of all terminal devices in the federated learning system related to the base station.

Optionally, the base station may calculate first importance weights of some terminal devices in the federated learning system related to the base station. For example, the base station may calculate first importance weights of some terminal devices, and the base station may indicate another terminal device to calculate the first importance weight of the terminal device.

Optionally, the base station may determine, based on one or more factors such as distribution of global data of the base station, system scheduling, communication link quality, computing power of the base station, and computing power of the terminal device, whether the base station calculates the first importance weight of the terminal device.

The distribution of the global data is distribution of local data corresponding to a plurality of terminal devices related to the base station during federated training. In other words, the base station collects the distribution of the local data corresponding to all terminal devices related to the base station during federated training, and performs integration, to obtain the distribution of the global data.

S320: The base station sends first indication information to the terminal device, where the first indication information indicates the terminal device to send a first parameter, and the first parameter is used to calculate the first importance weight by the base station.

Correspondingly, the terminal device receives the first indication information.

Optionally, the first parameter includes distribution of local data of the terminal device.

Optionally, the first parameter further includes a gradient corresponding to the local data of the terminal device. The gradient is obtained by the terminal device through calculation based on the local data.

S330: The terminal device sends the first parameter to the base station based on the first indication information.

Correspondingly, the base station receives the first parameter sent by the terminal device.

S340: The base station calculates the first importance weight based on the first parameter.

Optionally, the base station determines the distribution of the global data based on the distribution of the local data of the plurality of terminal devices associated with the base station during federated training.

Optionally, the base station calculates the first importance weight based on the first parameter and the distribution of the global data.

FIG. 4 is a method for calculating the first importance weight by the base station. As shown in FIG. 4, the method includes the following steps.

S410: The base station calculates a gradient Lipschitz coefficient of each category of data samples in multiple categories of data samples in the terminal device based on the distribution of the local data of the terminal device.

S420: The base station calculates the importance weight of each category of data samples in the multiple categories of data samples based on the gradient Lipschitz coefficient of each category of data samples in the multiple categories of data samples.

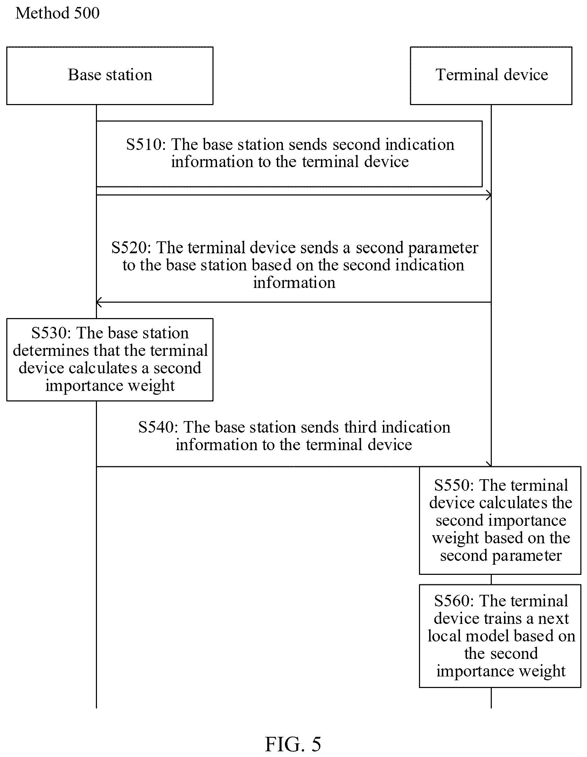

It should be noted that, in a communication method shown in FIG. 5, a step in which a terminal device calculates a second importance weight is similar to the step shown in FIG. 4, and only the base station needs to be replaced with the terminal device. Details are not described below.

In an embodiment, the first importance weight satisfies the following condition:

$$w_{N,n} = \frac{p_n + \alpha_{N,n}\Gamma_N}{p_{N,n}},$$

where

$p_{N,n}$ represents the distribution of the global data, where the distribution of the global data is the distribution of the local data corresponding to the plurality of terminal devices associated with the base station during federated training; $p_n$ is the distribution of the local data corresponding to the terminal device; N represents a quantity of the plurality of terminal devices; n represents that the terminal device is an $n^{th}$ terminal device; $\alpha_{N,n}$ is a gradient Lipschitz deviation of each

$$\alpha_{N,n} = \frac{1 - \frac{CL_{N,n}^2}{\Sigma_{j=1}^{C} L_{N,j}^2}}{\sqrt{\Sigma_{m=1}^{C}\left(1 - \frac{CL_{N,m}^2}{\Sigma_{j=1}^{C} L_{N,j}^2}\right)^2}}$$

category of data samples; and $\Gamma_N$ is a minimum non-negative value in $\frac{p_n - \sigma p_{N,n}}{-\alpha_{N,n}}$. is

the gradient Lipschitz deviation of each category of data samples, $\{L_{N,n}\} = \max_{z_n \in D_c} \frac{\|\nabla_\theta \ell(z_n; \theta_t^N) - \nabla_\theta \ell(z_n; \bar{\theta}_t)\|}{\|\theta_t^n - \bar{\theta}_t\|}$, $\bar{\theta}_t$

represents a global model, and $\theta_t^N$ represents a local model.

S350: The base station sends the first importance weight to the terminal device.

Correspondingly, the terminal device receives the first importance weight sent by the base station.

S360: The terminal device trains a next local model based on the first importance weight.

According to the communication method provided in this embodiment of this application, the problems of poor model precision and slow convergence are resolved by introducing importance weight sampling of each category of sample data of the terminal device and an interaction mechanism between the base station and the terminal device, where the problems arise from non-independent and identical distribution of local data of terminal devices participating in federated training. The importance weight is derived based on related theories by taking the following information into consideration: imbalance in distribution of different categories of samples and a gradient Lipschitz coefficient that affects model convergence, allowing pattern features of the different categories of samples to be learned by local models, and ensuring a controllable deviation between local models. In addition, deploying update of the importance weight in the base station, can fully utilize a computing power advantage of the base station, so as to release computing power of the terminal device.

FIG. 5 is another example of a communication method according to an embodiment of this application. As shown in FIG. 5, the method includes the following steps.

S510: A base station sends second indication information to a terminal device, where the second indication information indicates the terminal device to send a second parameter, and the second parameter is used to calculate a second importance weight.

Correspondingly, the terminal device receives the second indication information sent by the base station.

Specifically, the second importance weight is an importance weight of each category of data samples in multiple categories of data samples corresponding to the terminal device.

Optionally, the second parameter includes distribution of local data of the terminal device.

Optionally, the second parameter further includes a gradient corresponding to the local data of the terminal device. The gradient is obtained by the terminal device through calculation based on the local data.

S520: The terminal device sends the second parameter to the base station based on the second indication information.

Correspondingly, the base station receives the second parameter sent by the terminal device.

Optionally, the base station determines distribution of global data based on the second parameter. For the distribution of the global data, refer to the descriptions of the distribution of the global data in the method corresponding to FIG. 3. Details are not described herein again.

S530: The base station determines that the terminal device calculates the second importance weight.

S540: The base station sends third indication information to the terminal device, where the third indication information indicates that the terminal device calculates the second importance weight.

Correspondingly, the terminal device receives the third indication information sent by the base station.

S550: The terminal device calculates the second importance weight based on the second parameter.

Optionally, the method may further include: The terminal device receives the distribution of the global data sent by the base station, and calculates the second importance weight based on the second parameter and the distribution of the global data.

In some embodiments, the second importance weight satisfies the following condition:

$$w_{N,n} = \frac{p_n + \alpha_{N,n} \Gamma_N}{p_{N,n}},$$

where

$p_{N,n}$ represents the distribution of the global data, where the distribution of the global data is distribution of local data corresponding to a plurality of terminal devices associated with the base station during federated training; $p_n$ is the distribution of the local data corresponding to the terminal device; N represents a quantity of the plurality of terminal devices; n represents that the terminal device is an $n^{th}$ terminal device; $\alpha_{N,n}$ is a gradient Lipschitz deviation of each category of data samples; and $\Gamma_N$ is a minimum non-negative value in $\frac{p_n - \sigma p_{N,n}}{-\alpha_{N,n}}$.

S560: The terminal device trains a next local model based on the second importance weight.

According to the communication method provided in this embodiment of this application, a terminal device with remaining computing power or low federated update timeliness may update an importance weight locally, so that system scheduling pressure is reduced, and overall efficiency is further improved.

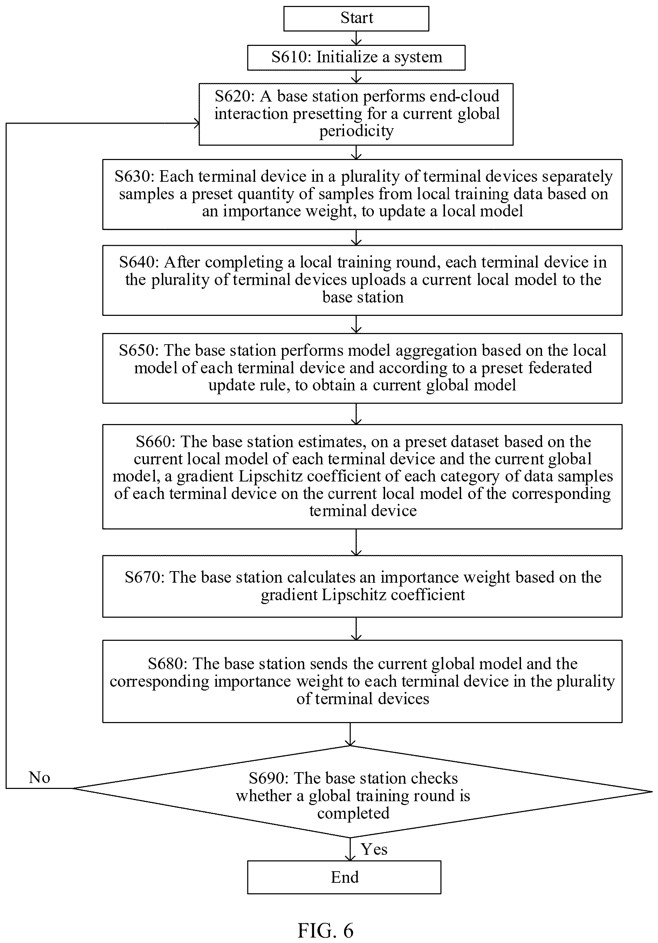

FIG. 6 is another example of a communication method according to an embodiment of this application. As shown in FIG. 6, the method includes the following steps.

S610: Initialize a system.

Specifically, the initialization includes presetting of a system parameter, initialization of a local model of a terminal device, initialization of an importance weight of each category corresponding to the terminal device, and configuration of a training hyperparameter.

S620: A base station performs end-cloud interaction presetting for a current global periodicity.

Optionally, a central server may be the base station.

S630: Each terminal device in a plurality of terminal devices separately samples a preset quantity of samples from local training data based on an importance weight, to update a local model.

For example, a process in which an $n^{th}$ terminal device trains a local model based on an importance weight may be as follows.

Step 6-1: The $n^{th}$ terminal device samples each category of data samples based on the importance weight, to form a data batch used to train the local model.

Step 6-2: The $n^{th}$ terminal device sequentially performs backpropagation on the data batch obtained through sampling, to update the local model.

Step 6-3: The $n^{th}$ terminal device checks whether a local training round is completed; and if the local training round is completed, ends the process; or if the local training round is not completed, performs step 6-1, and continues the training process.

S640: After completing the local training round, each terminal device in the plurality of terminal devices uploads a current local model to the base station.

S650: The base station performs model aggregation based on the local model of each terminal device and according to a preset federated update rule, to obtain a current global model.

S660: The base station estimates, on a preset dataset based on the current local model of each terminal device and the current global model, a gradient Lipschitz coefficient of each category of data samples of each terminal device on the current local model of the corresponding terminal device.

The preset dataset may be a preset dataset that is irrelevant to each terminal device, or may be a segment of dataset captured from data of each terminal device.

For example, the base station may estimate a gradient Lipschitz coefficient of each category of data samples in multiple categories of data samples of the $n^{th}$ terminal device in the current local model of the $n^{th}$ terminal device.

S670: The base station calculates an importance weight based on the gradient Lipschitz coefficient.

In other words, the base station updates the current importance weight based on the gradient Lipschitz coefficient.

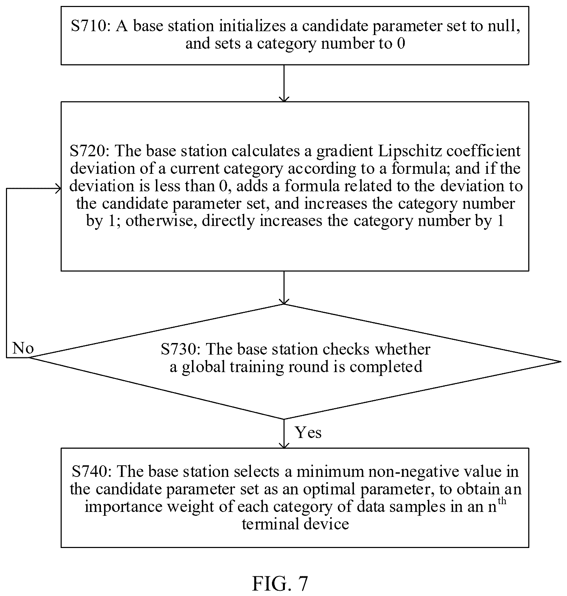

For example, FIG. 7 is a diagram of a process in which the base station calculates the importance weight of the $n^{th}$

terminal device. As shown in FIG. 7, the process may be as follows.

Step 710: The base station initializes a candidate parameter set to null, and sets a category number to 0.

Step 720: The base station calculates a gradient Lipschitz coefficient deviation $\alpha_n^N$ of a current category according to a formula; and if the deviation $\alpha_n^N$ is less than 0, adds $\frac{pn-\sigma p_{N,n}}{-\alpha_{N,n}}$ to the candidate parameter set, and increases the category number by 1; otherwise, directly increases the category number by 1.

Step 730: The base station determines whether all categories of data samples are traversed; and if yes, performs step 740; otherwise, performs step 720.

Step 740: The base station selects a minimum non-negative value in the candidate parameter set as an optimal parameter $\Gamma_N$, to obtain the importance weight $w_{N,n} = \frac{p_n + \alpha_{N,n}\Gamma_N}{p_{N,n}}$ of each category of data samples in the $n^{th}$ terminal device.

S680: The base station sends the current global model and the corresponding importance weight to each terminal device in the plurality of terminal devices.

S690: The base station checks whether a global training round is completed; and if the global training round is completed, ends the model training; otherwise, performs S620 for a loop.

According to the method provided in this embodiment of this application, importance weight sampling of each category of sample data of the terminal device and an interaction mechanism between the base station and the terminal device are introduced, to resolve problems such as poor precision and slow convergence of a model that are caused by non-independent and identical distribution of the local data of terminal devices. The importance weight derived based on related theories not only takes into account a distribution imbalance of different categories of samples, but also takes into account a gradient Lipschitz coefficient that affects model convergence, so that pattern features of the different categories of samples are learned by the local model, and a controllable deviation between local models is ensured. In addition, update of the importance weight is deployed in the base station, so that a computing power advantage of the base station can be fully utilized, and computing power of the terminal device can be released.

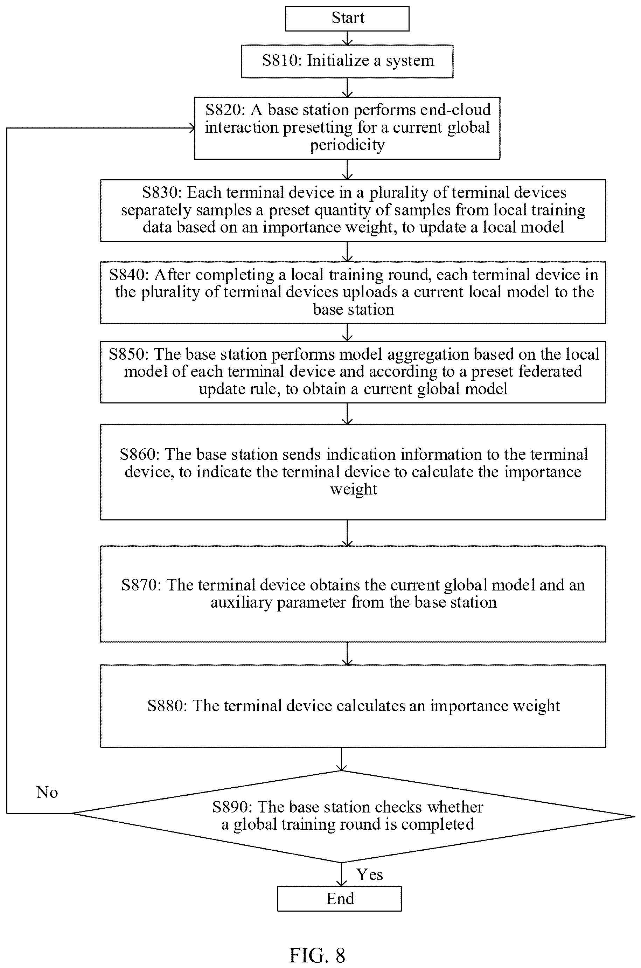

FIG. 8 is another example of a communication method according to an embodiment of this application. As shown in FIG. 8, the method includes the following steps.

S810: Initialize a system.

Specifically, the initialization includes presetting of a system parameter, initialization of a local model of a terminal device, initialization of an importance weight of each category corresponding to the terminal device, and configuration of a training hyperparameter.

S820: A base station performs end-cloud interaction presetting for a current global periodicity.

S830: Each terminal device in a plurality of terminal devices separately samples a preset quantity of samples from local training data based on an importance weight, to update a local model.

For example, for a process in which an $n^{th}$ terminal device trains a local model based on an importance weight, refer to the descriptions in step S630. Details are not described herein again.

S840: After completing the local training round, each terminal device in the plurality of terminal devices uploads a current local model to the base station.

S850: The base station performs model aggregation based on the local model of each terminal device and according to a preset federated update rule, to obtain a current global model.

S860: The base station sends indication information to the terminal device, to indicate the terminal device to calculate the importance weight.

It should be noted that, this step is optional.

S870: The terminal device obtains the current global model and an auxiliary parameter from the base station.

S880: The terminal device calculates an importance weight.

It should be noted that, for calculation of the importance weight, refer to the descriptions in S670, and only the base station needs to be replaced with the terminal device.

S890: The base station checks whether a global training round is completed; and if the global training round is completed, ends the model training; otherwise, performs S820 for a loop.

According to the communication method provided in this embodiment of this application, a distributed user with remaining computing power or low federated update timeliness may update an importance weight locally, so that system scheduling pressure is reduced, and overall efficiency is further improved.

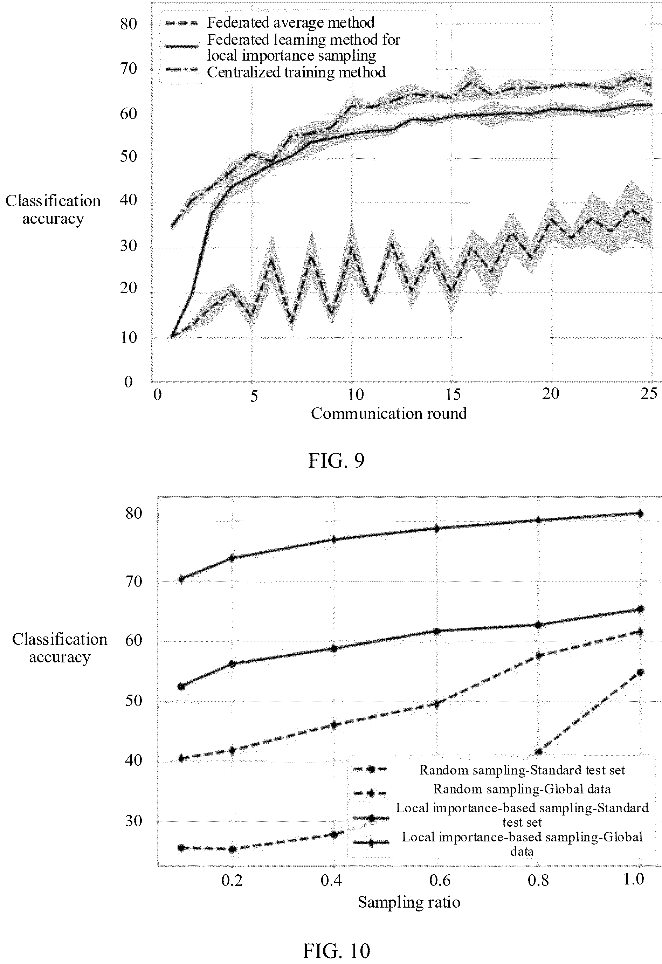

FIG. 9 is an example of a diagram of an effect of a communication method according to an embodiment of this application. FIG. 9 shows a comparison curve of a model accuracy with communication rounds. In set distribution of non-independent and identically distributed data, after 25 rounds of federated update, a classification accuracy of a global model on a standard test set is 64% on average, and is only about 6% lower than a classification accuracy of a model obtained through centralized training using all non-independent and identically distributed data.

FIG. 10 is an example of a diagram of an effect of a communication method according to an embodiment of this application. As shown in FIG. 10, for data sampling efficiency, a case in which some local data participates in training is considered. To be specific, in each round of local training iteration, only a specific proportion of data amounts is sampled for updating a local model. As a sampling ratio decreases, a classification accuracy of a global model of a federated learning algorithm designed in embodiments of this application decreases slightly, and a capability of dealing with insufficient computing resources, computing time, or samples of a local device is also significantly stronger than that of a random sampling method.

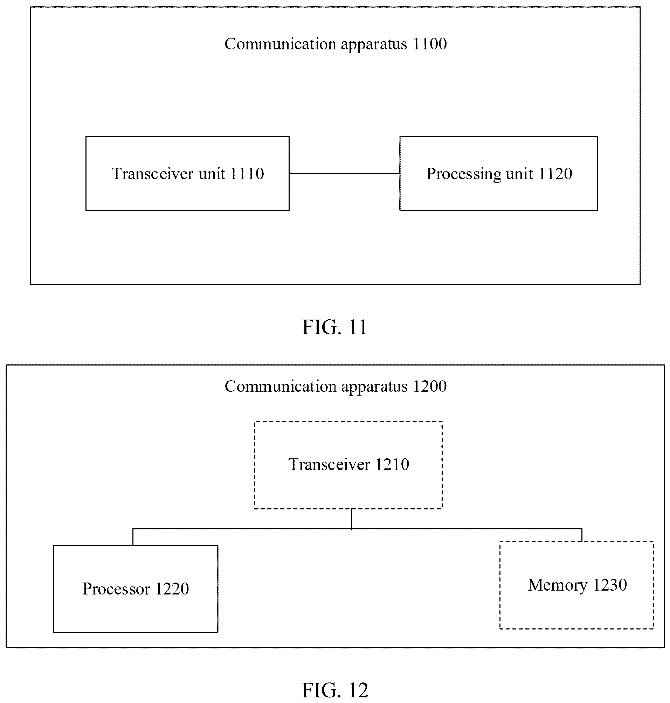

FIG. 11 is a diagram of an example of a communication apparatus according to an embodiment of this application. As shown in FIG. 11, the communication apparatus 1100 includes a transceiver unit 1110 and a processing unit 1120.

In some embodiments, the communication apparatus 1100 may be configured to implement a function of the terminal device in any one of the foregoing methods. For example, the communication apparatus 1100 may correspond to the terminal device.

The communication apparatus 1100 may be the terminal device, and performs steps performed by the terminal device in the foregoing method embodiments. The transceiver unit 1110 may be configured to support the communication apparatus 1100 in performing communication, for example, performing sending and/or receiving actions performed by the terminal device in the foregoing method embodiments. The processing unit 1120 may be configured to support the communication apparatus 1100 in performing processing actions in the foregoing method embodiments, for example, performing processing actions performed by the terminal device in the foregoing method embodiments.

Optionally, the communication apparatus may further include a storage unit 1130 (not shown in FIG. 11), configured to store program code and data of the communication apparatus.

In some embodiments, the communication apparatus 1100 may be configured to implement a function of the base station in any one of the foregoing methods. For example, the communication apparatus 1100 may correspond to the base station.

The communication apparatus 1100 may be the base station, and performs steps performed by the base station in the foregoing method embodiments. The transceiver unit 1110 may be configured to support the communication apparatus 1100 in performing communication, for example, performing sending and/or receiving actions performed by the base station in the foregoing method embodiments. The processing unit 1120 may be configured to support the communication apparatus 1100 in performing processing actions in the foregoing method embodiments, for example, performing processing actions performed by the base station in the foregoing method embodiments.

Optionally, the communication apparatus may further include a storage unit 1130 (not shown in FIG. 11), configured to store program code and data of the communication apparatus.

FIG. 12 is a diagram of another example of a communication apparatus according to an embodiment of this application. As shown in FIG. 12, an apparatus 1200 includes a transceiver 1210, a processor 1220, and a memory 1230. The memory 1230 is configured to store instructions. The processor 1220 is coupled to the memory 1230, and is configured to execute the instructions stored in the memory, to perform the foregoing method provided in embodiments of this application.

Specifically, the transceiver 1210 in the apparatus 1200 may correspond to the transceiver unit 1110 in the apparatus 1100, and the processor 1220 in the communication apparatus 1200 may correspond to the processing unit 1120 in the communication apparatus 1100.

It should be understood that, the memory 1210 and the processor 1220 may be combined into a processing apparatus, and the processor 1220 is configured to execute program code stored in the memory 1230, to implement the foregoing functions. During specific implementation, the memory 1230 may alternatively be integrated in the processor 1220 or independent of the processor 1220.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but such implementation is not to be considered outside of the scope of this application.

It may be clearly understood by a person skilled in the art that, for the purpose of convenient and brief descriptions, for a detailed working process of the foregoing system, apparatus, and unit, refer to a corresponding process in the foregoing method embodiments. Details are not described herein again.

In several embodiments provided in this application, it should be understood that, the disclosed system, apparatus, and method may be implemented in other manners. For example, the described apparatus embodiment is merely an example. For example, unit division is merely logical function division, and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate components may or may not be physically separate, and components displayed as units may or may not be physical units, may be located in one place, or may be distributed on a plurality of network units. Some or all of the units may be selected based on actual requirements to implement the objectives of the solutions of embodiments.

In addition, functional units in embodiments of this application may be integrated into one processing unit, each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions of this application essentially, or the part contributing to the related art, or a part of the technical solutions may be implemented in the form of a software product. The computer software product is stored in a storage medium and includes several instructions for instructing a computer device (which may be a personal computer, a server, a network device, or the like) to perform all or some of the steps of the methods described in embodiments of this application. The storage medium includes any medium that can store program code, such as a USB flash drive, a removable hard disk, a read-only memory (Read-Only Memory, ROM), a random access memory (Random Access Memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A model training method, comprising:

    calculating, by a first device, a gradient Lipschitz coefficient of each category of data samples in multiple categories of data samples in a terminal device based on distribution of local data of the terminal device; and calculating, by the first device, an importance weight of each category of data samples in the multiple categories of data samples based on the gradient Lipschitz coefficient of each category of data samples in the multiple categories of data samples, wherein importance weights of the multiple categories of data samples are used to train a next local model by the terminal device.

2. The method according to claim 1, wherein the importance weight satisfies the following condition:

$$w_{N,n} = \frac{p_n + \alpha_{N,n}\Gamma_N}{p_{N,n}},$$

wherein

$p_{N,n}$ represents distribution of global data, wherein the distribution of the global data is distribution of local data corresponding to a plurality of terminal devices associated with a base station during federated training; $p_n$ is the distribution of the local data corresponding to the terminal device; N represents a quantity of the plurality of terminal

$$\alpha_{N,n} = \frac{1 - \frac{CL_{N,n}^2}{\Sigma_{j=1}^{C} L_{N,j}^2}}{\sqrt{\Sigma_{m=1}^{C}\left(1 - \frac{CL_{N,m}^2}{\Sigma_{j=1}^{C} L_{N,j}^2}\right)^2}}$$

devices; n represents that the terminal device is an n$^{\text{th}}$ terminal device; is a gradient

$$\{L_{N,n}\} = \max_{z_n \in D_c} \frac{\left\|\nabla_\theta \ell(z_n;\theta_t^N) - \nabla_\theta \ell(z_n;\bar{\theta}_t)\right\|}{\left\|\theta_t^n - \bar{\theta}_t\right\|}$$

Lipschitz deviation of each category of data samples, wherein

$\bar{\theta}_t$ represents a global model, and $\theta_t^N$ represents a local model; and $\Gamma_N$ is a minimum non-negative value in

$$\frac{p_n - \sigma p_{N,n}}{-\alpha_{N,n}}.$$

**3.** The method according to claim 1, wherein the first device is a base station.

**4.** The method according to claim 1, wherein the first device is the terminal device.

**5.** A communication method, comprising:

determining, by a base station, to calculate a first importance weight, wherein the first importance weight is an importance weight of each category of data samples in multiple categories of data samples corresponding to a terminal device;

sending, by the base station, first indication information to the terminal device, wherein the first indication information indicates the terminal device to send a first parameter, and the first parameter is used to calculate the first importance weight by the base station;

receiving, by the base station, the first parameter sent by the terminal device;

calculating, by the base station, the first importance weight based on the first parameter; and

sending, by the base station, the first importance weight to the terminal device.

**6.** The method according to claim 5, wherein the first parameter comprises distribution of local data of the terminal device.

**7.** The method according to claim 6, wherein the first parameter further comprises a gradient corresponding to the local data of the terminal device.

**8.** The method according to any one of claims 5 to 7, wherein the method further comprises:

determining, by the base station, distribution of global data, wherein the distribution of the global data is distribution of local data corresponding to a plurality of terminal devices associated with the base station during federated training; and

the calculating, by the base station, the first importance weight based on the first parameter comprises:

calculating, by the base station, the first importance weight based on the first parameter and the distribution of the global data.

**9.** The method according to any one of claims 5 to 8, wherein the first importance weight satisfies the following condition:

$$w_{N,n} = \frac{p_n + \alpha_{N,n} \Gamma_N}{p_{N,n}},$$

wherein

$p_{N,n}$ represents the distribution of the global data, wherein the distribution of the global data is the distribution of the local data corresponding to the plurality of terminal devices associated with the base station during federated training; $p_n$ is the distribution of the local data corresponding to the terminal device; N represents a quantity of the plurality of terminal devices; n represents that the terminal device is an $n^{th}$ terminal device; $\alpha_{N,n}$ is a gradient Lipschitz deviation of each category of data samples; and $\Gamma_N$ is a minimum non-negative value in $\dfrac{p_n - \sigma p_{N,n}}{-\alpha_{N,n}}$.

**10.** A communication method, comprising:

receiving, by a terminal device, first indication information sent by a base station, wherein the first indication information indicates that the first indication information indicates the terminal device to send a first parameter, and the first parameter is used to calculate a first importance weight by the base station;

sending, by the terminal device, the first parameter to the base station based on the first indication information;

receiving, by the terminal device, the first importance weight sent by the base station; and

training, by the terminal device, a next local model based on the first importance weight.

11. The method according to claim 10, wherein the first parameter comprises distribution of local data of the terminal device.

12. The method according to claim 11, wherein the first parameter further comprises a gradient corresponding to the local data of the terminal device.

13. The method according to any one of claims 10 to 12, wherein the first importance weight satisfies the following condition:

$$w_{N,n} = \frac{p_n + \alpha_{N,n}\Gamma_N}{p_{N,n}},$$

wherein

$p_{N,n}$ represents distribution of global data, wherein the distribution of the global data is distribution of local data corresponding to a plurality of terminal devices associated with the base station during federated training; $p_n$ is the distribution of the local data corresponding to the terminal device; N represents a quantity of the plurality of terminal devices; n represents that the terminal device is an $n^{th}$ terminal device; $\alpha_{N,n}$ is a gradient Lipschitz deviation of each category of data samples; and $\Gamma_N$ is a minimum non-negative value in $\frac{p_n - \sigma p_{N,n}}{-\alpha_{N,n}}$.

14. A communication method, comprising:

sending, by a base station, second indication information to a terminal device, wherein the second indication information indicates the terminal device to send a second parameter, the second parameter is used to calculate a second importance weight, and the second importance weight is an importance weight of each category of data samples in multiple categories of data samples corresponding to the terminal device;
receiving, by the base station, the second parameter sent by the terminal device;
determining, by the base station, that the terminal device calculates the second importance weight; and
sending, by the base station, third indication information to the terminal device, wherein the third indication information indicates that the terminal device calculates the second importance weight.

15. The method according to claim 14, wherein the second parameter comprises distribution of local data of the terminal device.

16. The method according to claim 15, wherein the second parameter further comprises a gradient corresponding to the local data of the terminal device.

17. The method according to any one of claims 14 to 16, wherein the method further comprises:

determining, by the base station, distribution of global data, wherein the distribution of the global data is distribution of local data corresponding to a plurality of terminal devices associated with the base station during federated training; and
sending, by the base station, the distribution of the global data to the terminal device.

18. The method according to any one of claims 14 to 17, wherein the second importance weight satisfies the following condition:

$$w_{N,n} = \frac{p_n + \alpha_{N,n}\Gamma_N}{p_{N,n}},$$

wherein

$p_{N,n}$ represents the distribution of the global data, wherein the distribution of the global data is the distribution of the local data corresponding to the plurality of terminal devices associated with the base station during federated training; $p_n$ is the distribution of the local data corresponding to the terminal device; N represents a quantity of the plurality of terminal devices; n represents that the terminal device is an $n^{th}$ terminal device; $\alpha_{N,n}$ is a gradient Lipschitz deviation of each category of data samples; and $\Gamma_N$ is a minimum non-negative value in $\dfrac{p_n - \sigma p_{N,n}}{-\alpha_{N,n}}$.

19. A communication method, comprising:

receiving, by a terminal device, second indication information sent by a base station, wherein the second indication information indicates the terminal device to send a second parameter to the base station, the second parameter is used to calculate a second importance weight, and the second importance weight is an importance weight of each category of data samples in multiple categories of data samples corresponding to the terminal device;

sending, by the terminal device, the second parameter to the base station based on the second indication information;

receiving, by the terminal device, third indication information sent by the base station, wherein the third indication information indicates that the terminal device calculates the second importance weight;

calculating, by the terminal device, the second importance weight based on the second parameter; and

training, by the terminal device, a next local model based on the second importance weight.

20. The method according to claim 19, wherein the second parameter comprises distribution of local data of the terminal device.

21. The method according to claim 20, wherein the second parameter further comprises a gradient corresponding to the local data of the terminal device.

22. The method according to any one of claims 19 to 21, wherein the method further comprises:

receiving, by the terminal device, distribution of global data sent by the base station, wherein the distribution of the global data is distribution of local data corresponding to a plurality of terminal devices associated with the base station during federated training; and

the calculating, by the terminal device, the second importance weight based on the second parameter comprises: calculating, by the terminal device, the second importance weight based on the second parameter and the distribution of the global data.

23. The method according to any one of claims 19 to 22, wherein the second importance weight satisfies the following condition:

$$W_{N,n} = \frac{p_n + \alpha_{N,n}\Gamma_N}{p_{N,n}},$$

wherein

$p_{N,n}$ represents the distribution of the global data, wherein the distribution of the global data is the distribution of the local data corresponding to the plurality of terminal devices associated with the base station during federated training; $p_n$ is the distribution of the local data corresponding to the terminal device; N represents a quantity of the plurality of terminal devices; n represents that the terminal device is an $n^{th}$ terminal device; $\alpha_{N,n}$ is a gradient Lipschitz deviation of each category of data samples; and $\Gamma_N$ is a minimum non-negative value in $\dfrac{p_n - \sigma p_{N,n}}{-\alpha_{N,n}}$.

24. A communication device, comprising:

a memory, configured to store program instructions and data; and
a processor, configured to be coupled to the memory and execute the instructions in the memory, to implement the method according to any one of claims 5 to 9, or the method according to any one of claims 14 to 18.

25. A communication device, comprising:

a memory, configured to store program instructions and data; and
a processor, configured to be coupled to the memory and execute the instructions in the memory, to implement the method according to any one of claims 10 to 13, or the method according to any one of claims 19 to 23.

26. A computer-readable storage medium, wherein the computer-readable storage medium stores computer instructions, and when the computer instructions are run on a computer, the computer is enabled to perform the method according to any one of claims 5 to 13, or the method according to any one of claims 14 to 23.

27. A chip, comprising a processor and a memory, wherein the memory is configured to store a computer program, and the processor is configured to invoke and run a computer medium stored in the memory, to perform the method according to any one of claims 5 to 13, or the method according to claim 14 or 23.

Base station central server

Global model

...

Local model

Local data

User 1

Local model

Local data

User 2

...

Local model

Local data

User k

FIG. 1

Federated update
round data exchange

Local data statistics
information upload

Local importance weight
sampling update

Base station
central server

Model upload/
download

Local data → Sampler → Local model

FIG. 2

Method 300

| Base station | | Terminal device |
|---|---|---|

S310: The base station determines to calculate a first importance weight

S320: The base station sends first indication information to the terminal device

S330: The terminal device sends a first parameter to the base station based on the first indication information

S340: The base station calculates the first importance weight based on the first parameter

S350: The base station sends the first importance weight to the terminal device

S360: The terminal device trains a next local model based on the first importance weight

FIG. 3

Method 400

S410: A base station calculates a gradient Lipschitz coefficient of each category of data samples in multiple categories of data samples in a terminal device based on distribution of local data of the terminal device ⟶ S410

S420: The base station calculates an importance weight of each category of data samples in the multiple categories of data samples based on the gradient Lipschitz coefficient of each category of data samples in the multiple categories of data samples ⟶ S420

FIG. 4

Method 500

Base station

Terminal device

S510: The base station sends second indication
information to the terminal device

S520: The terminal device sends a second parameter
to the base station based on the second indication
information

S530: The base station
determines that the terminal
device calculates a second
importance weight

S540: The base station sends third indication
information to the terminal device

S550: The terminal
device calculates the
second importance
weight based on the
second parameter

S560: The terminal
device trains a next
local model based on
the second
importance weight

FIG. 5

Start

S610: Initialize a system

S620: A base station performs end-cloud interaction presetting for a current global periodicity

S630: Each terminal device in a plurality of terminal devices separately samples a preset quantity of samples from local training data based on an importance weight, to update a local model

S640: After completing a local training round, each terminal device in the plurality of terminal devices uploads a current local model to the base station

S650: The base station performs model aggregation based on the local model of each terminal device and according to a preset federated update rule, to obtain a current global model

S660: The base station estimates, on a preset dataset based on the current local model of each terminal device and the current global model, a gradient Lipschitz coefficient of each category of data samples of each terminal device on the current local model of the corresponding terminal device

S670: The base station calculates an importance weight based on the gradient Lipschitz coefficient

S680: The base station sends the current global model and the corresponding importance weight to each terminal device in the plurality of terminal devices

No — S690: The base station checks whether a global training round is completed

Yes

End

FIG. 6

S710: A base station initializes a candidate parameter set to null, and sets a category number to 0

S720: The base station calculates a gradient Lipschitz coefficient deviation of a current category according to a formula; and if the deviation is less than 0, adds a formula related to the deviation to the candidate parameter set, and increases the category number by 1; otherwise, directly increases the category number by 1

S730: The base station checks whether a global training round is completed

No

Yes

S740: The base station selects a minimum non-negative value in the candidate parameter set as an optimal parameter, to obtain an importance weight of each category of data samples in an $n^{th}$ terminal device

FIG. 7

Start

S810: Initialize a system

S820: A base station performs end-cloud interaction presetting for a current global periodicity

S830: Each terminal device in a plurality of terminal devices separately samples a preset quantity of samples from local training data based on an importance weight, to update a local model

S840: After completing a local training round, each terminal device in the plurality of terminal devices uploads a current local model to the base station

S850: The base station performs model aggregation based on the local model of each terminal device and according to a preset federated update rule, to obtain a current global model

S860: The base station sends indication information to the terminal device, to indicate the terminal device to calculate the importance weight

S870: The terminal device obtains the current global model and an auxiliary parameter from the base station

S880: The terminal device calculates an importance weight

No

S890: The base station checks whether a global training round is completed

Yes

End

FIG. 8

FIG. 9

FIG. 10

Communication apparatus 1100

Transceiver unit 1110 — Processing unit 1120

FIG. 11

Communication apparatus 1200

Transceiver 1210

Processor 1220

Memory 1230

FIG. 12

## INTERNATIONAL SEARCH REPORT

| International application No. |
| --- |
| **PCT/CN2022/109277** |

### A. CLASSIFICATION OF SUBJECT MATTER

G06F30/27(2020.01)i;G06N3/08(2023.01)i

According to International Patent Classification (IPC) or to both national classification and IPC

### B. FIELDS SEARCHED

Minimum documentation searched (classification system followed by classification symbols)

IPC:G06F,G06N,G06K,H04L

Documentation searched other than minimum documentation to the extent that such documents are included in the fields searched

Electronic data base consulted during the international search (name of data base and, where practicable, search terms used)

CNTXT; ENTXT; WPABS; VEN; CNKI: 联邦, 联合, 学习, 重要性, 权重, 权值, 梯度, 利普希茨, 系数, 偏差, 本地, 全局, 分布, 数据, 样本, 类别, federated, learning, importance, weight, gradient, lipschitz, constant, deviation, local, global, distribution, data, sample, type

### C. DOCUMENTS CONSIDERED TO BE RELEVANT

| Category* | Citation of document, with indication, where appropriate, of the relevant passages | Relevant to claim No. |
| --- | --- | --- |
| X | CN 112906864 A (SHENZHEN QIANHAI WEBANK CO., LTD.) 04 June 2021 (2021-06-04) claims 1-11 | 5-8, 10-12, 14-17, 19-22, 24-27 |
| A | CN 112906864 A (SHENZHEN QIANHAI WEBANK CO., LTD.) 04 June 2021 (2021-06-04) entire document | 1-4, 9, 13, 18, 23 |
| A | CN 109871702 A (SHENZHEN QIANHAI WEBANK CO., LTD.) 11 June 2019 (2019-06-11) entire document | 1-27 |
| A | CN 113158550 A (BEIJING UNIVERSITY OF POSTS AND TELECOMMUNICATIONS) 23 July 2021 (2021-07-23) entire document | 1-27 |
| A | WO 2021179196 A1 (GUANGDONG OPPO MOBILE TELECOMMUNICATIONS CORP., LTD.) 16 September 2021 (2021-09-16) entire document | 1-27 |

☐ Further documents are listed in the continuation of Box C.   ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
| --- | --- |
| **15 February 2023** | **21 February 2023** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

## INTERNATIONAL SEARCH REPORT
### Information on patent family members

| International application No. |
| --- |
| **PCT/CN2022/109277** |

| Patent document cited in search report | | | Publication date (day/month/year) | Patent family member(s) | Publication date (day/month/year) |
| --- | --- | --- | --- | --- | --- |
| CN | 112906864 | A | 04 June 2021 | None | |
| CN | 109871702 | A | 11 June 2019 | None | |
| CN | 113158550 | A | 23 July 2021 | None | |
| WO | 2021179196 | A1 | 16 September 2021 | None | |

Form PCT/ISA/210 (patent family annex) (July 2022)